# EUROPEAN PATENT SPECIFICATION

(11) **EP 4 374 431 B1**
(45) Date of publication and mention of the grant of the patent: **10.09.2025**
(21) Application number: 22748470.6
(22) Date of filing: 19.07.2022
(51) Int. Cl.: H02S 40/22, H10F 19/80

(54) **USE OF A FILM COMPRISING A POROUS POLYMER LAYER AS A SOLAR REFLECTOR AND SYSTEM FOR GENERATING ELECTRICITY COMPRISING THE SAME**
VERWENDUNG EINER FOLIE MIT EINER PORÖSEN POLYMERSCHICHT ALS SOLARREFLEKTOR UND SYSTEM ZUR STROMERZEUGUNG DAMIT
UTILISATION D'UN FILM COMPRENANT UNE COUCHE DE POLYMÈRE POREUX EN TANT QUE RÉFLECTEUR SOLAIRE ET SYSTÈME POUR GÉNÉRER DE L'ÉLECTRICITÉ COMPRENANT CELUI-CI

(30) Priority: 20.07.2021 IT 202100019178
(43) Date of publication of application: 29.05.2024
(73) Proprietor: SG1 S.r.l., 08100 Nuoro (IT)
(72) Inventor: FANELLI, Marco, 08100 Nuoro (IT)
(74) Representative: Palladino, Saverio Massimo
(86) International application number: PCT/IB2022/056638
(87) International publication number: WO 2023/002364

(56) References cited:
- EP-A1- 3 667 738
- WO-A1-2014/119055
- US-A1- 2012 048 375

## Description

### FIELD OF THE INVENTION

The present invention relates to systems for generating electricity from photovoltaic solar energy; more particularly, the present invention relates to the use of a multilayer film comprising a porous polymer layer with high reflectance and a metal substrate as a solar reflector in a system for generating electricity from photovoltaic solar energy comprising at least one bifacial photovoltaic module.

### STATE OF THE ART

Solar energy has long been considered an extremely interesting source of electricity due to its intrinsic characteristics of inexhaustibility over the human lifetime as well as its wide availability; moreover, the development of increasingly efficient solar energy harvesting and processing technologies are making it increasingly competitive with other energy sources, such as fossil fuels.

This is partly due to improvements in photovoltaic cells (whose efficiency is now normally between 20 and 22%) but mainly due to the reduction in the production costs of photovoltaic modules, which has led to a huge drop in prices to the public.

In most countries of the world, it has become increasingly cheaper to build solar parks than new coal- or gas-fired power stations. For large-scale solar projects completed in 2020, the average cost of electricity generation over the plant's lifetime (called LCOE, Levelized Cost Of Energy) was between $35 and $55 per megawatt-hour in some of the world's largest markets - the US, Europe, China and India. Only four years earlier, according to the World Economic Forum, the global average levelized cost for solar energy was $100 per megawatt-hour; about a decade earlier, it was $300.

In this context, photovoltaic solar energy exploitation is expected to increasingly dominate the energy market in the next decade, also driven by global efforts to tackle climate change.

The EU, for example, has set a target of obtaining 32% of its energy from renewable sources, including solar energy, by 2030.

Among the technological innovations related to the generation of electricity from solar energy, bifacial photovoltaic module technology is certainly one of the most promising. In fact, bifacial photovoltaic modules allow a more efficient collection of solar energy, because they are able to absorb solar energy from both sides of the photovoltaic cell, increasing energy production compared to a conventional photovoltaic module. While a traditional photovoltaic module for electricity production exploits only the side facing the sun, a bifacial one also exploits the opposite side, i.e. in the shade, which is affected by the solar radiation reflected and diffused by the underlying surface: the ability of a surface to reflect incident radiation is known as the "albedo" of the surface, expressed through a coefficient, known as the albedo coefficient.

Bifacial module technology is not new: the first laboratory-scale bifacial cells date back to the 1960s and the technology was first commercialised in the early 1980s. Although it has therefore been a well-known technology for some time, the use of bifacial photovoltaic modules did not find wide market acceptance until at least the 2010s, in part due to the technical and functional limitations still persisting in improving the productivity of the side in the shade, also due to the extreme variability of the albedo coefficients of the reflective surfaces that direct solar radiation onto it. An example of a bifacial module comprising a reflector is described in patent publication WO2014119055A1.

### SUMMARY OF THE INVENTION

The aim of the present invention is therefore to overcome, by offering an innovative solution, the technical and functional limitations that persist in improving the productivity of bifacial photovoltaic modules for generating electricity from solar energy. In accordance with the present invention, the Applicant has surprisingly found that it is possible to pursue the above-mentioned purpose by using a multilayer film comprising a porous polymer layer with high reflectance and a support layer as a solar reflector, for the purpose of reflecting solar radiation to be directed to the shaded side of a bifacial photovoltaic module.

Thus, in a first aspect thereof, the present invention concerns the use of a multilayer film comprising:
- at least one support layer, and
- at least one layer of a porous polymer material coupled to said support layer, said porous polymer material comprising a continuous phase of at least one polymer, wherein said porous polymer material has a hierarchical porosity structure comprising a first population of pores and a second population of pores, wherein the first population of pores has a diameter comprised between 1.5 and 7.5 microns and wherein the second population of pores has a diameter comprised between 0.05 and 0.6 microns,
as a solar reflector for a bifacial photovoltaic module.

The Applicant has in fact surprisingly found that through the use of said multilayer film it is possible to obtain particularly high reflectance values, which can be measured by means of a UV-VIS-NIR spectrophotometer and integrating sphere, as well as particularly efficiently directing reflected and diffuse solar radiation mainly on the shaded side of a bifacial photovoltaic module in the case of prevailing direct radiation (clear sky) and even, in the case of prevailing diffuse radiation (cloudy or otherwise unclear sky), on both sides of said module, thus improving its performance in a wide range of weather conditions.

The increase in performance achievable through the use of the multilayer film according to the present invention is also advantageously accompanied by a further improvement in terms of reducing the physical and economic resources required to achieve the increase in productivity, compared to other solutions of the prior art. In particular, the Applicant noted that the specific combination of a support layer of metallized polymer material with a layer of a porous polymer material having a specific hierarchical porosity structure, results in a multilayer film having a lower density and thickness than conventional reflector films, for the same performance, thus leading to savings in terms of material and production costs compared to the latter.

In a further aspect, the present invention also relates to a system for generating electricity from solar energy, comprising:
- at least one bifacial photovoltaic module (1), said bifacial photovoltaic module (1) comprising a first side (10) adapted to receive a direct solar radiation (RSD) comprising a first plurality of photovoltaic cells (11,12,13) and a second side (20) comprising a second plurality of photovoltaic cells (21,22,23), said second side (20) opposite to the first side (10);
- at least one solar reflector (2) positioned at said bifacial photovoltaic module (1) and adapted to direct a reflected and diffused solar radiation (RSR) on said second side (20), wherein said solar reflector (2) is a multilayer film comprising: at least one support layer, at least one layer of a porous polymer material coupled to said support layer, said porous polymer material comprising a continuous phase of at least one polymer, wherein said porous polymer material has a hierarchical porous structure comprising a first population of pores and a second population of pores, wherein the first population of pores has a diameter comprised between 1.5 and 7.5 microns and wherein the second population of pores has a diameter comprised between 0.05 and 0.6 microns.

The advantages and the characteristics of said further aspect have already been underlined with reference to the first aspect of the invention and will not be herein repeated.

### BRIEF DESCRIPTION OF THE DRAWINGS

Figure 1 shows a schematic representation not to scale of a side view of a system for generating electricity from solar energy of the photovoltaic type according to the invention; and
Figure 2 shows an SEM photomicrograph of a cross-section of the porous layer obtained in Example 1.

### DETAILED DESCRIPTION OF THE INVENTION

The present invention relates in a first aspect thereof to the use of a multilayer film comprising:
at least one support layer, and
at least one layer of a porous polymer material coupled to said support layer, said porous polymer material comprising a continuous phase of at least one polymer, wherein said porous polymer material has a hierarchical porosity structure comprising a first population of pores and a second population of pores, wherein the first population of pores has a diameter comprised between 1.5 and 7.5 microns and wherein the second population of pores has a diameter comprised between 0.05 and 0.6 microns,
as a solar reflector for a bifacial photovoltaic module.

The Applicant has in fact surprisingly found that through the use of said multilayer film it is possible to obtain particularly high reflectance values, which can be measured by means of a UV-VIS-NIR spectrophotometer and integrating sphere, as well as particularly efficiently directing reflected and diffuse solar radiation mainly on the shaded side of a bifacial photovoltaic module in the case of prevailing direct radiation (clear sky) and even, in the case of prevailing diffuse radiation (cloudy or otherwise unclear sky), on both sides of said module, thus improving its performance in a wide range of weather conditions.

The increase in performance achievable through the use of the multilayer film according to the present invention is also advantageously accompanied by a further improvement in terms of reducing the physical and economic resources required to achieve the increase in productivity, compared to other solutions of the prior art. In particular, the Applicant noted that the specific combination of a support layer of metallized polymer material with a layer of a porous polymer material having a specific hierarchical porosity structure, results in a multilayer film having a lower density and thickness than conventional reflector films, for the same performance, thus leading to savings in terms of material and production costs compared to the latter.

Within the context of the present description and following claims, all the numerical magnitudes indicating quantities, parameters, percentages, and so on are to be considered preceded in every circumstance by the term "about" unless indicated otherwise. Further, all the ranges of numerical magnitudes include all the possible combinations of maximum and minimum numerical values and all the possible intermediate ranges, as well as those indicated below.

In the context of this description and the subsequent claims, the expression:
- "reflectance" refers to the ability to reflect part of the incident light onto a given surface material. Since it is therefore the ratio of reflected radiant flux intensity to incident radiant flux intensity, it is a dimensionless quantity;
- "hierarchical porosity" refers to the property of a material to exhibit at the same time a microstructure with porosity of different scales, which can be classified, depending on pore diameter measurements, as micro- (less than 2 nm), meso- (between 2 and 50 nm) and macro- (greater than 50 nm) scales;

The present invention can be presented in one or more of its aspects or one or more of the preferred characteristics reported below, which can be combined with one another according to the application requirements.

The multilayer film according to the present invention comprises at least one support layer.

Preferably, said support layer is made of non-woven fabric or metallized polymer material.

When said support layer is made of metallized polymer material, it preferably comprises a support made of polymer material and a metal coating, wherein the polymer of said polymer material is selected from the group consisting of poly(ethylene terephthalate) (PET), poly(styrene) (PS), poly(vinyl chloride) (PVC), poly(propylene) (PP), poly(ethylene) (PE), or mixtures thereof, and wherein the metal of said metal coating is selected from the group consisting of aluminium, silver, or mixtures thereof.

In said embodiment, the polymer material is preferably PET and the metal coating is preferably aluminium.

In a preferred embodiment, the metal coating of the metallized polymer layer is in direct contact with the porous polymer layer of the multilayer film according to the present invention.

This embodiment is particularly preferred and allows for a multilayer film with a high diffuse spectral reflectance.

The multilayer film according to the present invention further comprises at least one layer of a porous polymer material coupled to the support layer.

The porous polymer material of the multilayer film according to the present invention comprises a continuous phase of at least one polymer, wherein said porous polymer material has a hierarchical porosity structure comprising a first population of pores and a second population of pores, wherein the first population of pores has a diameter comprised between 1.5 and 7.5 microns and wherein the second population of pores has a diameter comprised between 0.05 and 0.6 microns.

Preferably, said first population of pores has an average diameter comprised between 4 and 7 microns.

Preferably, said second population of pores has an average diameter comprised between 0.1 and 0.4 microns.

In fact, the Applicant has found that populations of pores having average diameters in the ranges defined above enable the performance of the multilayer film according to the present invention to be optimized, making it possible to obtain a porous polymer layer having high diffuse spectral reflectance.

Layers of porous polymer material having different populations of pores or not porous at all, although capable of reflecting solar radiation and thus also acting as solar reflectors, have, on the other hand, shown more limited performance for the same material used and in any case significantly less than the layer of porous polymer material having the characteristics according to the present invention.

The structure of the layer of porous polymer material of the multilayer film according to the present invention can be determined according to techniques known to a person skilled in the art. For example, it is possible to determine the average diameter of the first and second population of pores by analysing the images obtained by Scanning Electron Microscope (SEM), after gold metallization, either by analysing the surface of the porous layer or by analysing the cross-section thereof, visible at the extremes of the sample, and subsequently analysing the images obtained using dedicated Image J 1.53e software.

Preferably, the porous polymer material layer of the multilayer film according to the present invention has a thickness comprised between 0.01 and 2 millimetres, more preferably between 0.05 and 1 millimetres, even more preferably between 0.1 and 0.6 millimetres, even more preferably between 0.15 and 0.5 millimetres.

Said thickness value can be determined using techniques known to a person skilled in the art, e.g. by measuring with an electronic gauge at different points of the material used.

The porous polymer material of the multilayer film according to the present invention comprises a continuous phase of at least one polymer preferably selected from the group consisting of: poly(vinylidene fluoride) (PVDF), poly(vinylidene fluoride-co-hexafluoropropylene) (PVDF-HFP), poly(methyl methacrylate) (PMMA), poly(styrene) (PS).

Preferably, said at least one polymer is selected from the group consisting of: poly(vinylidene fluoride), poly(methyl methacrylate) (PMMA), poly(vinylidene fluoride-co-hexafluoropropylene), or mixtures thereof, more preferably poly(vinylidene fluoride) and poly(vinylidene fluoride-co-hexafluoropropylene), even more preferably poly(vinylidene fluoride-co-hexafluoropropylene), due to the improved properties in terms of solubility, hydrophobicity, and mechanical strength, and the increased fluorine content with the incorporation of HFP groups, compared to standard PVDF.

Poly(vinylidene fluoride) (PVDF) and poly(vinylidene fluoride-co-hexafluoropropylene) (PVDF-HFP) are two fluoropolymers, also commonly referred to as fluorinated polymers, i.e. a class of polymers bearing a carbon-fluorine bond that is well known to a person skilled in the art and widely available commercially. The use of fluoropolymers such as PVDF and PVDF-HFP ensures greater durability over time and less degradation than traditional materials due to their excellent resistance to atmospheric agents and UV radiation. Furthermore, said fluoropolymers exhibit characteristics of solubility with organic solvents and processability to obtain membranes that, compared to other fluoropolymers such as PTFE, reduce the energy impact, cost and complexity of the production process for the preparation of the multilayer film according to the present invention.

Known fluoropolymers suitable for use in the present invention are poly(vinylidene fluoride) (PVDF), Solef^{®} 1010,11010 PVDF acetone soluble, manufactured by Solvay, and poly(vinylidene fluoride-co-hexafluoropropylene) (PVDF-HFP), Solef^{®} 21216 PVDF-HFP acetone soluble copolymer, manufactured by Solvay.

In addition to the continuous phase of a polymer, the porous polymer material of the multilayer film according to the present invention preferably comprises at least one release agent, more preferably selected from the group consisting of: silica, talc, a silicate, a molybdate, or mixtures thereof.

Said release additive reduces fouling and facilitates cleaning of the porous polymer layer of the multilayer film, thus enabling it to maintain a high efficiency value over time during use.

When present, said at least one release agent is comprised in the porous polymer material in an amount comprised between 20 and 25% by weight, with respect to the total weight of the polymer of the continuous phase of the porous polymer material.

In addition to the release agent, the porous polymer material according to the present invention may contain one or more other additives, which are normally used and known to a person skilled in the art in the field of multilayer films; for example, additives which may be present in the porous polymer material are plasticizers, organic and/or inorganic fillers, lubricants, nucleating agents, surfactants, antistatic agents, pigments, flame retardant agents.

The multilayer film according to the present invention may also advantageously comprise one or more photoactive compounds, e.g. titanium dioxide, alumina, barium sulphate.

Indeed, the Applicant has found that said compounds contribute to improving the performance of the multilayer film according to the present invention in terms of solar radiation reflectance.

In the multilayer film according to the present invention, said one or more photoactive compounds such as, for example, titanium dioxide, alumina, barium sulphate, may be dispersed in the porous polymer layer or support layer, or may be included in one or more further layers of the multilayer film itself.

The Applicant has also found that a film comprising said one or more photoactive compounds such as, for example, titanium dioxide, alumina, barium sulphate can also be used, optionally coupled to a support layer, as a solar reflector for a bifacial photovoltaic module, although it exhibits lower performance in terms of reflectance and durability with respect the multilayer film according to the present invention.

The multilayer film according to the present invention can be made according to any method known to a person skilled in the art.

The support layer can be obtained directly on the market, where such materials are generally available, for example, in roll form. Support layers comprising a support made of polymer material and a metallic coating can also be produced by PVD deposition of a metal (e.g. aluminium) on a film made of polymer material (e.g. PET), in a manner known to a person skilled in the art and therefore not further detailed here.

The porous polymer material of the multilayer film can be coupled to the support layer after its preparation or be directly prepared on said support layer.

The porous polymer material can be prepared by any method known to a person skilled in the art; it can, for example, be applied directly to the support layer in the form of a liquid varnish, or it can be produced either directly on the support layer or be prepared and then coupled to the support layer after its preparation by means of a phase inversion method, a phase separation method with selective solvent attack, or aerogel production methods.

Phase inversion methods are generally preferred due to their lower cost and greater flexibility; they can utilize different desolvation mechanisms, are known to the person skilled in the art, and are mainly based on four main types of phase inversion methods: non-Solvent Induced Phase Separation (NIPS), Vapour-induced Phase Separation (VIPS), Thermally Induced Phase Separation (TIPS) and Solvent Evaporation Induced Phase Separation (SEIPS). Phase inversion methods using supercritical CO₂ are also known.

Preferably, the porous polymer material according to the present invention is prepared by means of a Non-Solvent Induced Phase Separation (NIPS) phase inversion method.

In a preferred embodiment, the method for preparing the multilayer film according to the present invention comprises the steps of:
- preparing a support layer of metallized polymer material;
- arranging a porous polymer material comprising a continuous phase of at least one polymer preferably selected from the group consisting of: poly(vinylidene fluoride) (PVDF), poly(vinylidene fluoride-co-hexafluoropropylene) (PVDF-HFP), poly(methylmethacrylate) (PMMA), poly(styrene) (PS), wherein said porous polymer material exhibits a hierarchical porosity structure comprising a first population of pores and a second population of pores, wherein the first population of pores has a diameter comprised between 1.5 to 7.5 microns and wherein the second population of pores has a diameter comprised between 0.05 to 0.6 microns; and
- coupling said layer of said porous polymer material to said support layer.

Preferably, this step of preparing a support layer comprises the step of applying a metal coating selected from the group consisting of aluminium, silver, or mixtures thereof, more preferably aluminium, by means of PVD (Physical Vapour Deposition) on a support made of polymer material selected from the group consisting of PET, PS, PVC, PP, or mixtures thereof, most preferably PET.

Optionally, a removable layer of protective paper can be applied to said support layer; said removable layer prevents the deposition of dust and dirt during intermediate steps and is advantageously removed before the subsequent process steps.

The support layer can be made in any form that is useful for the preparation of a multilayer film; advantageously, it is made in the form of a film, which can then be collected on a reel, for example.

Preferably, the step of preparing the porous polymer material according to the present invention involves a non-solvent induced phase separation (NIPS) method. Due to its compositional and porosity characteristics, the porous polymer layer is able to exhibit high diffuse spectral reflectance.

Preferably, in said non-solvent induced phase separation (NIPS) method, the solvent is selected from the group consisting of acetone (Ac), N,N-dimethylformamide (DMF), N,N-dimethylacetamide(DMAc) dimethylsulphoxide (DMSO), hexamethylphosphoramide (HMPA), N-methyl-2-pyrrolidone (NMP), tetramethylurea (TMU), triethylphosphate (TEP), trimethylphosphate (TMP), DMF/Ac mixture, methyl ethyl ketone (MEK), tetrahydrofuran (THF).

Preferably, in said non-solvent induced phase separation (NIPS) method in the starting solution the weight ratio of said fluoropolymer to solvent ranges from 1:2 to 1:30, more preferably 1: 5 to 1: 15, even more preferably it ranges from 1: 7 to 1: 9.

Preferably, in said non-solvent induced phase separation (NIPS) method the non-solvent is water.

In a preferred embodiment, said non-solvent induced phase separation (NIPS) method comprises the steps of
- preparing a solution of at least one polymer, preferably selected from the group consisting of: poly(vinylidene fluoride) (PVDF), poly(vinylidene fluoride-co-hexafluoropropylene) (PVDF-HFP), poly(methyl methacrylate) (PMMA), poly(styrene) (PS), in at least one solvent;
- optionally, adding to said solution at least one release agent, advantageously selected from silica, talc, a silicate, a molybdate, or mixtures thereof;
- applying said solution on a flat surface, so as to obtain a layer having a thickness preferably less than or equal to 0.5 mm;
- subjecting said layer to phase inversion by adding water; and
- drying said layer, preferably by heating so that the water and solvent evaporate.

In an embodiment, said flat surface is the support layer of the multilayer film according to the present invention.

Once made, the multilayer film according to the present invention is advantageously stored and/or collected in the form of, for example, a reel, prior to its use as a solar reflector for a bifacial photovoltaic module.

In a further aspect, the present invention also relates to a system (100) for generating electricity from solar energy, comprising:
- at least one bifacial photovoltaic module (1), said bifacial photovoltaic module (1) comprising a first side (10) adapted to receive a direct solar radiation (RSD) comprising a first plurality of photovoltaic cells (11,12,13) and a second side (20) comprising a second plurality of photovoltaic cells (21,22,23), said second side (20) opposite to the first side (10);
- at least one solar reflector (2) positioned at said bifacial photovoltaic module (1) and adapted to direct a reflected and diffused solar radiation (RSR) on said second side (20), wherein said solar reflector (2) is a multilayer film comprising: at least one support layer, at least one layer of a porous polymer material coupled to said support layer, said porous polymer material comprising a continuous phase of at least one polymer, wherein said porous polymer material has a hierarchical porous structure comprising a first population of pores and a second population of pores, wherein the first population of pores has a diameter comprised between 1.5 and 7.5 microns and wherein the second population of pores has a diameter comprised between 0.05 and 0.6 microns.

The advantages and the characteristics of said further aspect have already been underlined with reference to the first aspect of the invention and will not be herein repeated.

Preferably, the multilayer film of the system for generating electricity from solar energy according to this aspect of the invention has one or more preferred characteristics of the multilayer film according to the first aspect of the invention.

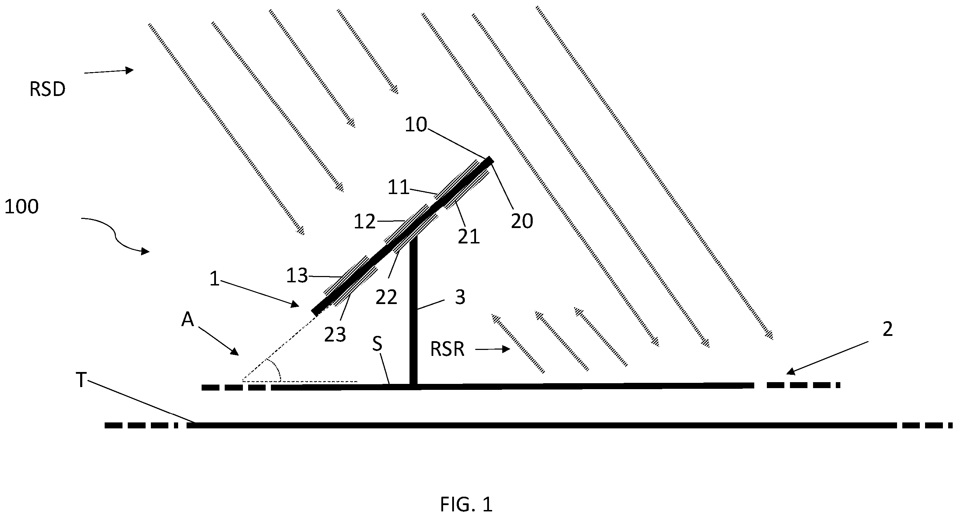

Figure 1 shows a schematic representation not to scale of a side view of a system for generating electricity from solar energy according to a first possible embodiment of the invention. The system 100 depicted in Figure 1 comprises the bifacial photovoltaic module 1, and the solar reflector 2.

The photovoltaic module 1 is shown schematically from the side in Figure 1 and is installed on a support 3. The module 1 comprises a first side 10 and a second side 20 opposite the first side 10. The first side 10 comprises photovoltaic cells 11, 12, and 13, while the second side 20 comprises photovoltaic cells 21, 22, and 23.

The first side 10 is positioned to receive direct RSD solar radiation and via the photovoltaic cells 11, 12 and 13 converts said solar radiation into electricity.

At the photovoltaic module 1, the solar reflector 2 is positioned, which consists of a multilayer film comprising a support layer consisting of a polymer support of PET and a metallic coating of aluminium, and associated in direct contact with said metallic coating of aluminium a porous layer consisting of a continuous phase of poly(vinylidene fluoride-co-hexafluoropropylene) having a hierarchical porosity structure comprising a first population of pores with a diameter comprised between 1.5 and 7.5 microns and a second population of pores with a diameter comprised between 0.05 and 0.6 microns.

In the system 100, the solar reflector 2 is oriented essentially parallel to the ground surface line T, spaced from it by supports and guides not shown in Figure 1. The solar reflector 2 is also positioned in such a way that its reflective surface S forms an angle A comprised between -70 and 70 ° with respect to the plane defined by the second side 20 of the photovoltaic module 1. In other embodiments not illustrated herein, the solar reflector 2 can also be more inclined with respect to the ground surface and form a different angle A with respect to the plane defined by the second side 20 of the photovoltaic module 1.

The surface S of the solar reflector receives the direct solar radiation RSD and, by reflecting it, directs the reflected and diffuse solar radiation RSR onto the second side 20 of the photovoltaic module 1, which via the photovoltaic cells 21, 22 and 23 converts this solar radiation into electricity.

Further characteristics and advantages of the invention will be more clear from the following Examples, which are intended for illustrative and non-limiting purposes only.

### EXPERIMENTAL PART

### Example 1

A solution was prepared by dissolving 40 grams of poly(vinylidene fluoride-co-hexafluoropropylene) (Solef^{®} 21216 produced by Solvay) in 408 millilitres of acetone, corresponding to approximately 320 grams. The solution was applied to a glass surface, so as to obtain a layer of about 1 millimetre of uniform thickness.

This layer was subjected to a phase inversion process by adding water, manually spraying around 200 millilitres of deionized water at 25 °C over its entire surface, thus obtaining a semi-finished product already in membrane form. This semi-finished product was then turned upside down, so as to place the surface already exposed to water in contact with the glass surface and leave the opposite surface exposed, on which a further 200 millilitres of water at 25 °C was then manually sprayed.

The resulting layer was then dried at room temperature 25-30 °C for 24 hours, and exposed to the sun to accelerate the evaporation process so that the acetone and water could evaporate, resulting in a porous layer consisting of a continuous poly(vinylidene fluoride-co-hexafluoropropylene) phase with a hierarchical pore structure comprising a first population of pores with a diameter comprised between 1.5 to 7.5 microns and a second population of pores with a diameter comprised between 0.05 and 0.6 microns. The porous layer exhibited a specific gravity of 0.77grams/cm³; this value was about 56% lower than the standard density of a non-porous PVDF HFP film, thus testifying to the advantage in terms of production costs and material use of the multilayer film according to the present invention with respect to non-porous reflector films of the known art.

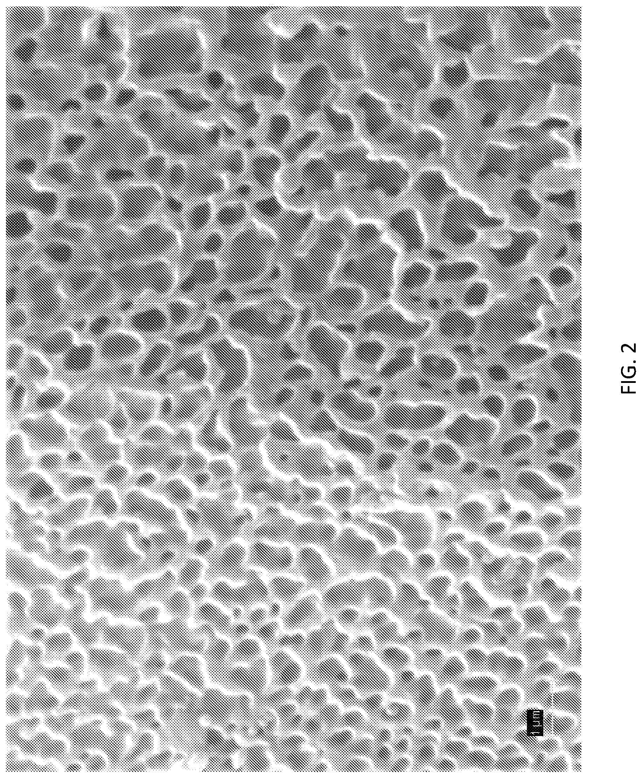

Figure 2 shows an SEM photomicrograph of a cross-section of the porous layer obtained with a Zeiss scanning electron microscope with a stated limit resolution of 1.5 nm, thus suitable for detecting the combination of different nanoporosity diameters useful for achieving diffuse reflectance. There is no need to measure nanopores smaller than 50nm (0.05 microns), as they are not relevant to the effect of increasing diffuse reflectance. From the photomicrograph it is possible to appreciate, by comparing it with the reference scale shown in the figure itself, the presence of a hierarchical porosity structure comprising a first population of pores and a second population of pores, wherein the first population of pores has a diameter comprised between 1.5 and 7.5 microns and wherein the second population of pores has a diameter comprised between 0.05 and 0.6 microns.

The porous layer thus obtained was then manually applied and taped to one of the two sides of the metallized support, consisting of an aluminized poly(ethylene terephthalate) film (KD90 manufactured by QHM manufacturing), resulting in a multilayer film.

### Example 2 (comparison)

A photovoltaic system as depicted schematically in Figure 1 was made using a bifacial photovoltaic module model of the HJT - Ahony type with a power of 5W, Pmax: 5Wp, Voltage at Pmax: 6 V Current at Pmax: 0.84 A Open circuit Voltage: 7.08 V, L (18x18 cm), bifaciality index 90%. The photovoltaic module was installed on a support with a height of 0.75 times the side of the module and in such a way as to tilt the plane defined by the shaded side of the bifacial photovoltaic module according to different configurations described in table 1 with respect to the ground line, on which a flat ceramic floor was laid.

The photovoltaic system was commissioned and tested in order to measure its electricity production capacity. For measurement purposes, a load-simulated system consisting of individually connected photovoltaic modules was used: ESP32 ESP-WROOM-32, ACS712 5A sensors, metal film resistors, 10W ceramic cement resistors, Raspberry Pi 4.

The results obtained are reported in Table 1.

### Example 3 (comparison)

A photovoltaic system was made as in Example 2 (comparison), in which, however, at a height from the ground of 75% of the module width and parallel to the ground line, a solar reflector made from a non-porous poly(tetrafluoroethylene) peel-off Tekfilm produced by Guarniflon by means of compression moulding with a thickness of 0.2 mm and a width of 25 cm and length of 25 cm was positioned.

The photovoltaic system made in this way was commissioned and tested simultaneously with the system according to Example 2 (comparison) and Example 4, making sure to maintain the same orientation of the two photovoltaic modules with respect to the sun throughout the duration of the test, so as to ensure the same conditions of exposure to solar radiation for both.

The results obtained are reported in Table 1.

### Example 4

A photovoltaic system was made as in Example 2 (comparison), at which, however, at a height from the ground equal to 75% of the module width and parallel to the ground line, a solar reflector made with the multilayer film according to Example 1 and having a width of 25 and a length of 25 cm was positioned.

The photovoltaic system made in this way was commissioned and tested simultaneously with the system according to Example 2 (comparison) and Example 3 (comparison), making sure to maintain the same orientation of the two photovoltaic modules with respect to the sun throughout the duration of the test, so as to ensure the same conditions of exposure to solar radiation for both.

The results obtained are reported in Table 1.

**Table 1**

| Module Orientation | Single-axis tracker | | | | | | Dual-axis tracker | | |
|---|---|---|---|---|---|---|---|---|---|
| Weather conditions | Clear sky | | | Cloudy sky | | | Slightly cloudy sky | | |
| | Volt | Ampere | Watt | Volt | Ampere | Watt | Volt | Ampere | Watt |
| **Example 2 (comparison)** | 4.1 | 0.72 | 2.95 | 3 | 0.08 | 0.24 | 5.3 | 0.64 | 3.39 |
| **Example 3 (comparison)** | 4.1 | 0.73 | 2.99 | 3 | 0.12 | 0.38 | 5.3 | 0.70 | 3.71 |
| **Example 4** | 4.1 | 0.8 | 3.28 | 3 | 0.14 | 0.42 | 5.3 | 0.76 | 4.028 |

From the comparison of the data obtained from Examples 2 (comparison) and 3 (comparison) with Example 4 according to the invention shown in Table 1, it was possible to show that the use according to the invention of the multilayer film according to Example 1 as a solar reflector for a bifacial photovoltaic module enabled a significant increase in the performance of the system for generating electricity from solar energy, even compared to a reflector made from a non-porous poly(tetrafluoroethylene) film. In particular, the multilayer film according to Example 1 used as a solar reflector in Example 4 made it possible to increase, compared to Example 2 (comparison without reflector), the instantaneous productivity from 11% to 19% in the case of prevalence of direct radiation, and by 75% in the case of prevalence of diffuse radiation (cloudy sky). These increases are greater than the 2 to 9% increase in the case of direct radiation, and 61% in the case of diffuse radiation, which can be achieved by using the reflector according to Example 3, made from a non-porous poly(tetrafluoroethylene) film. It is relevant to mention that the reported percentage increases use the performance of a bifacial module as the basis for measuring the incremental component only guaranteed by the present invention. In reality, for the purposes of a possible industrial investment, the mere choice of a bifacial panel over a standard monofacial module can guarantee a basic increase of 4 to 10% in the productivity of a plant without the use of reflectors. This increase was not taken into account when calculating the increase in productivity of the present invention. Thus, the increase in the overall productivity of the photovoltaic system, compared to standard solutions based on monofacial modules, can rely both on the normal 4-10% obtainable by choosing bifacial modules without reflectors, and on the percentage increase provided by the reflectors, as described by the present invention. The two combined increases therefore facilitate the adoption of bifacial technology on a large scale.

## Claims

1. Use of a multilayer film (2) comprising:
at least one support layer, and
at least one layer of a porous polymer material coupled to said support layer, said porous polymer material comprising a continuous phase of at least one polymer, wherein said porous polymer material has a hierarchical porosity structure comprising a first population of pores and a second population of pores, wherein the first population of pores has a diameter comprised between 1.5 and 7.5 microns and wherein the second population of pores has a diameter comprised between 0.05 and 0.6 microns,
as a solar reflector for a bifacial photovoltaic module (1).

2. Use according to claim 1, wherein said support layer is made of non-woven fabric or a metallized polymer material.

3. The use according to claim 2, wherein said layer of metallized polymer material comprises a support made of polymer material and a metal coating, wherein the polymer of said polymer material is selected from the group consisting of poly(ethylene terephthalate) (PET), poly(styrene) (PS), poly(vinyl chloride) (PVC), poly(propylene) (PP), poly(ethylene) (PE), or mixtures thereof, and wherein the metal of said metal coating is selected from the group consisting of aluminium, silver, or mixtures thereof.

4. The use according to claim 3, wherein the metallic coating of the metallized polymer material layer is in direct contact with said porous polymer layer.

5. Use according to any one of claims 1 to 4, wherein said porous polymer layer has a thickness comprised between 0.01 and 2 millimetres.

6. Use according to any one of claims 1 to 5, wherein said at least one polymer is selected from the group consisting of: poly(vinylidene fluoride) (PVDF), poly(vinylidene fluoride-co-hexafluoropropylene) (PVDF-HFP), poly(methyl methacrylate) (PMMA), poly(styrene) (PS).

7. Use according to claim 6, wherein said at least one polymer is selected from the group consisting of: poly(vinylidene fluoride), poly(vinylidene fluoride-co-hexafluoropropylene), poly(methyl methacrylate) (PMMA).

8. Use according to any one of claims 1 to 7, wherein said porous polymer material comprises at least one release agent.

9. A system (100) for generating electricity from solar energy, comprising:
- at least one bifacial photovoltaic module (1), said bifacial photovoltaic module (1) comprising a first side (10) adapted to receive a direct solar radiation (RSD) comprising a first plurality of photovoltaic cells (11,12,13) and a second side (20) comprising a second plurality of photovoltaic cells (21,22,23), said second side (20) opposite to the first side (10);
- at least one solar reflector (2) positioned at said bifacial photovoltaic module (1) and adapted to direct a reflected and diffused solar radiation (RSR) on said second side (20), **characterized in that**:
said solar reflector (2) is a multilayer film comprising: at least one support layer, and at least one layer of a porous polymer material coupled to said support layer, said porous polymer material comprising a continuous phase of at least one polymer, wherein said porous polymer material has a hierarchical porous structure comprising a first population of pores and a second population of pores, wherein the first population of pores has a diameter comprised between 1.5 and 7.5 microns and wherein the second population of pores has a diameter comprised between 0.05 and 0.6 microns.

10. The system according to claim 9, wherein said multilayer film has one or more characteristics according to any one of claims 2 to 8.

## Patentansprüche

1. Verwendung einer Mehrschichtfolie (2), umfassend:
mindestens eine Trägerschicht und
mindestens eine Schicht aus einem porösen Polymermaterial, die mit der Trägerschicht gekoppelt ist, wobei das poröse Polymermaterial eine kontinuierliche Phase aus mindestens einem Polymer umfasst,
wobei das poröse Polymermaterial eine hierarchische Porositätsstruktur aufweist, die einen ersten Bestand an Poren und einen zweiten Bestand an Poren umfasst, wobei der erste Bestand an Poren einen Durchmesser zwischen 1,5 und 7,5 Mikrometern aufweist und wobei der zweite Bestand an Poren einen Durchmesser zwischen 0,05 und 0,6 Mikrometern aufweist,
als Solarreflektor für ein bifaziales Photovoltaikmodul (1).

2. Verwendung nach Anspruch 1, wobei die Trägerschicht aus einem Vliesstoff oder einem metallisierten Polymermaterial hergestellt ist.

3. Verwendung nach Anspruch 2, wobei die Schicht aus metallisiertem Polymermaterial einen aus einem Polymermaterial und einer Metallbeschichtung hergestellten Träger umfasst, wobei das Polymer des Polymermaterials aus der Gruppe bestehend aus Poly(ethylenterephthalat) (PET), Poly(styrol) (PS), Poly(vinylchlorid) (PVC), Poly(propylen) (PP), Poly(ethylen) (PE) oder Mischungen davon ausgewählt ist, und wobei das Metall der Metallbeschichtung aus der Gruppe bestehend aus Aluminium, Silber oder Mischungen davon ausgewählt ist.

4. Verwendung nach Anspruch 3, wobei die Metallbeschichtung der metallisierten Polymermaterialschicht in direktem Kontakt mit der porösen Polymerschicht steht.

5. Verwendung nach einem der Ansprüche 1 bis 4, wobei die poröse Polymerschicht eine Dicke zwischen 0,01 und 2 Millimetern aufweist.

6. Verwendung nach einem der Ansprüche 1 bis 5, wobei das mindestens eine Polymer aus der Gruppe bestehend aus: Poly(vinylidenfluorid) (PVDF), Poly(vinylidenfluorid-co-hexafluorpropylen) (PVDF-HFP), Poly(methylmethacrylat) (PMMA), Poly(styrol) (PS) ausgewählt ist.

7. Verwendung nach Anspruch 6, wobei das mindestens eine Polymer aus der Gruppe bestehend aus: Poly(vinylidenfluorid), Poly(vinylidenfluorid-co-hexafluorpropylen), Poly(methylmethacrylat) (PMMA) ausgewählt ist.

8. Verwendung nach einem der Ansprüche 1 bis 7, wobei das poröse Polymermaterial mindestens ein Trennmittel umfasst.

9. System (100) zur Stromerzeugung aus Solarenergie, umfassend:
- mindestens ein bifaziales Photovoltaikmodul (1), wobei das bifaziale Photovoltaikmodul (1) eine erste Seite (10) umfasst, die dazu geeignet ist, eine direkte Sonneneinstrahlung (RSD, direct solar radiation) zu empfangen und die eine erste Vielzahl von Photovoltaikzellen (11, 12, 13) umfasst, und eine zweite Seite (20), die eine zweite Vielzahl von Photovoltaikzellen (21, 22, 23) umfasst, wobei die zweite Seite (20) der ersten Seite (10) gegenüberliegt;
- mindestens einen Solarreflektor (2), der an dem bifazialen Photovoltaikmodul (1) positioniert ist und dazu geeignet ist, eine reflektierte und gestreute Sonneneinstrahlung (RSR, reflected and diffused solar radiation) auf die zweite Seite (20) zu lenken, **dadurch gekennzeichnet, dass**:
der Solarreflektor (2) eine Mehrschichtfolie ist, umfassend:
mindestens eine Trägerschicht und mindestens eine Schicht aus einem porösen Polymermaterial, die mit der Trägerschicht gekoppelt ist, wobei das poröse Polymermaterial eine kontinuierliche Phase aus mindestens einem Polymer umfasst, wobei das poröse Polymermaterial eine hierarchische Porositätsstruktur aufweist, die einen ersten Bestand an Poren und einen zweiten Bestand an Poren umfasst, wobei der erste Bestand an Poren einen Durchmesser zwischen 1,5 und 7,5 Mikrometern aufweist und wobei der zweite Bestand an Poren einen Durchmesser zwischen 0,05 und 0,6 Mikrometern aufweist.

10. System nach Anspruch 9, wobei die Mehrschichtfolie eine oder mehrere Eigenschaften nach einem der Ansprüche 2 bis 8 aufweist.

## Revendications

1. Utilisation d'un film multicouche (2) comprenant :
au moins une couche de support, et
au moins une couche d'un matériau polymère poreux couplée à ladite couche de support, ledit matériau polymère poreux comprenant une phase continue d'au moins un polymère,
dans laquelle ledit matériau polymère poreux a une structure de porosité hiérarchique comprenant une première population de pores et une deuxième population de pores, dans laquelle la première population de pores a un diamètre compris entre 1,5 et 7,5 microns et dans laquelle la deuxième population de pores a un diamètre compris entre 0,05 et 0,6 microns,
comme réflecteur solaire pour un module photovoltaïque bifacial (1).

2. Utilisation selon la revendication 1, dans laquelle ladite couche de support est constituée d'un tissu non tissé ou d'un matériau polymère métallisé.

3. Utilisation selon la revendication 2, dans laquelle ladite couche de matériau polymère métallisé comprend un support en matériau polymère et un revêtement métallique, dans laquelle le polymère dudit matériau polymère est choisi dans le groupe constitué par le polyéthylène téréphtalate (PET), le polystyrène (PS), le polychlorure de vinyle (PVC), le polypropylène (PP), le polyéthylène (PE), ou des mélanges de ceux-ci, et dans laquelle le métal dudit revêtement métallique est choisi dans le groupe constitué par l'aluminium, l'argent, ou des mélanges de ceux-ci.

4. Utilisation selon la revendication 3, dans laquelle le revêtement métallique de la couche de matériau polymère métallisé est en contact direct avec ladite couche de polymère poreux.

5. Utilisation selon l'une quelconque des revendications 1 à 4, dans laquelle ladite couche de polymère poreux a une épaisseur comprise entre 0,01 et 2 millimètres.

6. Utilisation selon l'une quelconque des revendications 1 à 5, dans laquelle ledit au moins un polymère est choisi dans le groupe constitué par : le polyfluorure de vinylidène (PVDF), le polyfluorure de vinylidène co-hexafluoropropylène (PVDF-HFP), le polyméthacrylate de méthyle (PMMA), le polystyrène (PS).

7. Utilisation selon la revendication 6, dans laquelle ledit au moins un polymère est choisi dans le groupe constitué par : le polyfluorure de vinylidène, le polyfluorure de vinylidène co-hexafluoropropylène, le polyméthacrylate de méthyle (PMMA).

8. Utilisation selon l'une quelconque des revendications 1 à 7, dans laquelle ledit matériau polymère poreux comprend au moins un agent de libération.

9. Système (100) pour générer de l'électricité à partir de l'énergie solaire, comprenant :
- au moins un module photovoltaïque bifacial (1), ledit module photovoltaïque bifacial (1) comprenant un premier côté (10) adapté pour recevoir un rayonnement solaire direct (RSD) comprenant une première pluralité de cellules photovoltaïques (11, 12, 13) et un deuxième côté (20) comprenant une deuxième pluralité de cellules photovoltaïques (21, 22, 23), ledit deuxième côté (20) étant opposé au premier côté (10) ;
- au moins un réflecteur solaire (2) positionné au niveau dudit module photovoltaïque bifacial (1) et adapté pour diriger un rayonnement solaire réfléchi et diffusé (RSR) sur ledit deuxième côté (20), **caractérisé en ce que** :
ledit réflecteur solaire (2) est un film multicouche comprenant :
au moins une couche de support, et au moins une couche d'un matériau polymère poreux couplée à ladite couche de support, ledit matériau polymère poreux comprenant une phase continue d'au moins un polymère, dans lequel ledit matériau polymère poreux a une structure poreuse hiérarchique comprenant une première population de pores et une deuxième population de pores, dans lequel la première population de pores a un diamètre compris entre 1,5 et 7,5 microns et dans lequel la deuxième population de pores a un diamètre compris entre 0,05 et 0,6 microns.

10. Système selon la revendication 9, dans lequel ledit film multicouche a une ou plusieurs caractéristiques selon l'une quelconque des revendications 2 à 8.
